# EUROPEAN PATENT SPECIFICATION

(11) **EP 3 475 986 B1**
(45) Date of publication and mention of the grant of the patent: **11.10.2023**
(21) Application number: 17815936.4
(22) Date of filing: 12.06.2017
(51) Int. Cl.: H01L 31/05, H01L 31/0224, H01L 31/18, C25D 1/04, C25D 1/08

(54) **CELL-TO-CELL INTERCONNECT**
VERBINDUNG VON ZELLE ZU ZELLE
INTERCONNEXION CELLULE-À-CELLULE

(30) Priority: 24.06.2016 US 201615192576
(43) Date of publication of application: 01.05.2019
(73) Proprietor: Merlin Solar Technologies, Inc., San Jose, California 95138 (US)
(72) Inventor: MURALI, Venkatesan, San Jose, California 95120 (US); CHILD, Kent Riley, San Jose, California 95138 (US); RUDIN, Arthur, San Jose, California 95138 (US); BRAILOVE, Adam, San Jose, California 95138 (US); CHARI, Arvind, San Jose, California 95138 (US)
(74) Representative: Haseltine Lake Kempner LLP
(86) International application number: PCT/US2017/036963
(87) International publication number: WO 2017/222852

(56) References cited:
- EP-A1- 2 309 553
- EP-A1- 2 309 553
- WO-A1-2014/158585
- US-A1- 2013 269 748
- US-A1- 2014 124 014
- US-A1- 2014 137 922
- US-A1- 2015 129 024

## Description

### RELATED APPLICATIONS

The application is a continuation-in-part of U.S. Patent Application No. 15/192,576 filed on June 24, 2016 and entitled "Cell-to-Cell Interconnect".

### BACKGROUND OF THE INVENTION

A solar cell is a device that converts photons into electrical energy. The electrical energy produced by the cell is collected through electrical contacts coupled to the semiconductor material, and is routed through interconnections with other photovoltaic cells in a module. The "standard cell" model of a solar cell has a semiconductor material, used to absorb the incoming solar energy and convert it to electrical energy, placed below an anti-reflective coating (ARC) layer, and above a metal backsheet. Electrical contact is typically made to the semiconductor surface with fire-through paste, which is metal paste that is heated such that the paste diffuses through the ARC layer and contacts the surface of the cell. The paste is generally patterned into a set of fingers and bus bars which will then be soldered with ribbon to other cells to create a module. Another type of solar cell has a semiconductor material sandwiched between transparent conductive oxide layers (TCO's), which are then coated with a final layer of conductive paste that is also configured in a finger/bus bar pattern.

Several solar cells may be connected together to form a solar cell circuit. In a solar cell circuit, a conductive area coupled to a p-doped region ("positive area") of one solar cell is connected to a conductive area coupled to an n-doped region ("negative area") of an adjacent solar cell. The positive area of the adjacent solar cell is then connected to a negative area of a next adjacent solar cell and so on. This chaining of solar cells may be repeated to connect several solar cells in series to increase the output voltage of the solar cell circuit. Solar cells are generally connected with a flat wire or ribbon soldered onto the solar cell. It is known in the art that the interconnects between cells are prone to breakage and warping during transportation, installation and normal thermal cycling. For example, solar cell circuits may experience failures in the field due to fatigue of the interconnect which may occur during transportation from shock and vibration, or in service due to thermal cycling and mechanical stress such as by wind buffeting or snow loading. Failure of the interconnect may lead to arcing that could then result in fire.

Moreover, as a result of its higher coefficient of thermal expansion, the interconnect, such as a wire or ribbon, may contract much more than the solar cell upon cooling from soldering thereby cracking solar cells at the connection. Of greater concern, differential contraction can form microscopic cracks in the solar cell, which can enlarge when the solar cells are stressed. Cracking can cause long term problems including reduced reliability, mechanical failure, and power decay.

Conventionally, solar cells are interconnected by a three bus bar configuration. Three bus bar interconnects often cause warpage in the solar cell due to their natural in-plane inflexibility or rigidness between adjacent solar cells. The three bus bar configuration also has a redundancy of three interconnections between adjacent solar cells. Therefore, if any single interconnection fails, the solar cell loses efficiency and may pose a fire hazard due to solar cell overheating.

US 2015/0129024 discloses an electrical component, and method of making the component, which includes a metallic article having a plurality of elongated elements that are configured to serve as electrical conduits for a photovoltaic cell.

### SUMMARY OF THE INVENTION

The invention is as defined in and by the appended claims. A metallic article for a photovoltaic cell is disclosed. The metallic article includes a first region having a plurality of electroformed elements that are configured to serve as an electrical conduit for a light-incident surface of the photovoltaic cell. A cell-to-cell interconnect is integral with the first region. The cell-to-cell interconnect is configured to extend beyond the light-incident surface and to directly couple the metallic article to a neighboring photovoltaic cell. The cell-to-cell interconnect includes a plurality of electroformed, curved appendages. Each appendage has a first end coupled to an edge of the first region and a second end opposite the first end and away from the edge. The appendages are spaced apart from each other. The metallic article is a unitary, free-standing piece.

A metallic article for a photovoltaic cell is also disclosed. The metallic article includes a first region having a plurality of elements that are configured to serve as an electrical conduit for a light-incident surface of the photovoltaic cell. A cell-to-cell interconnect is integral with the first region. The cell-to-cell interconnect extends beyond the light-incident surface and directly couples the metallic article to a neighboring photovoltaic cell. The cell-to-cell interconnect includes a link having a first link end coupled to an edge of the first region, a second link end opposite the first link end and away from the edge of the first region and a tapered neck along a length of the link. The cell-to-cell interconnect includes a plurality of appendages. Each appendage has a first end coupled to an edge of the first region and a second end opposite the first end and away from the edge of the first region. An appendage length that is greater than the length of the link. The appendages are spaced apart from each other. The metallic article is a unitary, free-standing piece.

### BRIEF DESCRIPTION OF THE DRAWINGS

Each of the aspects and embodiments of the invention described herein can be used alone or in combination with one another. The aspects and embodiments will now be described with reference to the attached drawings.
FIG. 1 shows a perspective view of an electroforming mandrel in accordance with some examples.
FIGs. 2A-2C depict cross-sectional views of stages in producing a free-standing electroformed metallic article in accordance with some examples.
FIG. 3 provides a top view of a metallic article with adaptable features, in accordance with some examples.
FIGs. 4A-4B are a close-up view of a cell-to-cell interconnect in accordance with some examples.
FIGs. 4C-4K depict a partial view of the cell interconnect with various shapes of appendages in accordance with some examples.
FIGs. 4L-4N show the metallic article with the cell-to-cell interconnect in accordance with some examples.
FIGs. 5A-5C depict a method of processing for the metallic article in accordance with some examples.
FIG. 5D depicts the metallic article in accordance with some examples.
FIG. 6 illustrates a top view of the cell-to-cell interconnect coupled to the front side of one photovoltaic cell and the back side of a neighboring photovoltaic cell in accordance with some examples.
FIGs. 7A-7C illustrate side views of the cell-to-cell interconnect between two adjacent photovoltaic cells in accordance with some examples.
FIG. 8 illustrates a perspective view of the metallic article as part of the photovoltaic cell in accordance with some examples.
FIG. 9 shows photovoltaic cells with metallic articles, forming a module assembly, in accordance with some examples.
FIG. 10 is a flowchart of a method for forming photovoltaic modules using metallic articles of the present disclosure in accordance with some examples.

### DETAILED DESCRIPTION OF THE EMBODIMENTS

Metallization of solar cells is conventionally achieved with screen printed silver pastes on the surface of the cell, and cell-to-cell interconnections that utilize solder-coated ribbons. For a given aspect ratio of a metal conduit, the electrical resistance is inversely proportional to its footprint. Therefore, the cell metallization or cell-to-cell interconnection design usually trades off between shading and resistance for the most optimized solar cell module power output. The metallic articles of the present disclosure, which shall also be referred to as grids or meshes, can be used to replace conventional silver paste and solder coated ribbons and have adaptable features that allow for decoupling of factors that conventionally require trade-offs between functional requirements.

In Babayan et al., U.S. Patent Application No. 13/798,123, issued as U.S. Patent No. 8,916,038, electrical conduits for semiconductors such as photovoltaic cells are fabricated as an electroformed free-standing metallic article. The metallic articles are produced separately from a solar cell and can include multiple elements such as fingers and bus bars that can be transferred stably as a unitary piece and easily aligned to a semiconductor device. The elements of the metallic article are formed integrally with each other in the electroforming process. The metallic article is manufactured in an electroforming mandrel, which generates a patterned metal layer that is tailored for a solar cell or other semiconductor device. For example, the metallic article may have grid lines with height-to-width aspect ratios that minimize shading for a solar cell. The metallic article can replace conventional bus bar metallization and ribbon stringing for cell metallization, cell-to-cell interconnection and module making. The ability to produce the metallization layer for a photovoltaic cell as an independent component that can be stably transferred between processing steps provides various advantages in material costs and manufacturing.

Disclosed herein is a metallic article for a photovoltaic cell. The metallic article includes a first region having a plurality of electroformed elements that are configured to serve as an electrical conduit for a light-incident surface of the photovoltaic cell. A cell-to-cell interconnect is integral with the first region. The cell-to-cell interconnect is configured to extend beyond the light-incident surface and to directly couple the metallic article to a neighboring photovoltaic cell. The cell-to-cell interconnect includes a plurality of electroformed, curved appendages. Each appendage has a first end coupled to an edge of the first region and a second end opposite the first end and away from the edge. The appendages are spaced apart from each other. The metallic article is a unitary, free-standing piece.

In one example, each appendage of the plurality of appendages may be an hourglass shape. The first region may comprise a first plane and the cell-to-cell interconnect may comprise a bend that places the second ends of the plurality of electroformed appendages in a second plane different from the first plane. The bend may be configured at an angle of 5° to 85° relative to the plane of the metallic article. The cell-to-cell interconnect may protrude from the first plane by 0.2-0.4 mm. The cell-to-cell interconnect may protrude from the second plane by 0.3-0.6 mm.

The cell-to-cell interconnect may span at least one quarter of the edge of the first region. In one example, the thickness of the cell-to-cell interconnect may comprise a height that is different from a height of the plurality of electroformed elements.

The plurality of electroformed elements may comprise a plurality of first elements intersecting a plurality of second elements. The plurality of first elements may be perpendicular to the edge of the first region. A width of each first element may vary along a length of the first element.

In one example, the metallic article may further comprise a metallic strip integral with the cell-to-cell interconnect and coupled to the second ends of the plurality of electroformed appendages. The metallic strip may be configured to be coupled to a back side of the neighboring photovoltaic cell.

A method of forming an electrical component for a photovoltaic cell is also disclosed. The method comprises electroforming a metallic article on an electrically conductive mandrel. The electrically conductive mandrel has an outer surface comprising at least one preformed pattern, and comprises a first region having a plurality of electroformed elements and a cell-to-cell interconnect integral with the first region. The cell-to-cell interconnect has a plurality of electroformed, curved appendages. The metallic article is separated from the electrically conductive mandrel. The plurality of electroformed elements is interconnected such that the metallic article forms a unitary, free-standing piece when separated from the electrically conductive mandrel. The plurality of electroformed elements is configured to serve as an electrical conduit for a light-incident surface of the photovoltaic cell. The cell-to-cell interconnect is configured to extend beyond the light-incident surface and to directly couple the metallic article to a neighboring photovoltaic cell. The cell-to-cell interconnect comprises a plurality of electroformed, curved appendages. Each appendage has a first end coupled to an edge of the first region and a second end opposite the first end and away from the edge. The appendages are spaced apart from each other.

Disclosed herein is a metallic article for a photovoltaic cell. The metallic article includes a first region having a plurality of elements that are configured to serve as an electrical conduit for a light-incident surface of the photovoltaic cell. A cell-to-cell interconnect is integral with the first region. The cell-to-cell interconnect extends beyond the light-incident surface and directly couples the metallic article to a neighboring photovoltaic cell. The cell-to-cell interconnect includes a link having a first link end coupled to an edge of the first region, a second link end opposite the first link end and away from the edge of the first region and a tapered neck along a length of the link. The cell-to-cell interconnect includes a plurality of appendages. Each appendage has a first end coupled to an edge of the first region and a second end opposite the first end and away from the edge of the first region. An appendage length that is greater than the length of the link. The appendages are spaced apart from each other. The metallic article is a unitary, free-standing piece.

The link is linear and is perpendicular to the edge of the first region. The cell-to-cell interconnect is designed to break at the neck when a force is applied to the cell-to-cell interconnect.

Each appendage of the plurality of appendages is hourglass shaped, S-shaped, U-shaped, W-shaped, V-shaped, serpentine shaped, saw-tooth shaped or L-shaped. In some examples, the appendage length is a path length along the appendage, and the appendage length is from 1.4 to 3 times the length of the link. An angle between the tangent of the appendage and a horizontal edge of the first region is at least 12°. The appendage is repeated at least 8 times per centimeter, at least 10 per centimeter, or at least 12 per centimeter.

In some examples, the first region and the cell-to-cell interconnect are located in the same plane. The metallic article further comprises a metallic strip integral with the cell-to-cell interconnect and coupled to the second ends of the plurality of appendages. The metallic strip is configured to be coupled to a back side of the neighboring photovoltaic cell. Each appendage traverses a non-perpendicular path between the edge of the first region and the metallic strip. The cell-to-cell interconnect further comprises a crossbar extending across the plurality of appendages and connecting one appendage to a neighboring appendage.

A method of forming an electrical component for a photovoltaic cell is also disclosed. The method includes electroforming a metallic article on an electrically conductive mandrel. The, electrically conductive mandrel has an outer surface comprising at least one preformed pattern. The metallic article includes a first region having a plurality of electroformed elements and a cell-to-cell interconnect integral with the first region. The metallic article is separated from the electrically conductive mandrel. The plurality of electroformed elements is interconnected such that the metallic article forms a unitary, free-standing piece when separated from the electrically conductive mandrel. The plurality of electroformed elements is configured to serve as an electrical conduit for a light-incident surface of the photovoltaic cell. The cell-to-cell interconnect extends beyond the light-incident surface and directly couples the metallic article to a neighboring photovoltaic cell. The cell-to-cell interconnect includes a link having a first link end coupled to an edge of the first region, a second link end opposite the first link end and away from the edge of the first region and a tapered neck along a length of the link. The cell-to-cell interconnect includes a plurality of appendages. Each appendage has a first end coupled to an edge of the first region and a second end opposite the first end and away from the edge of the first region. An appendage length that is greater than the length of the link. The appendages are spaced apart from each other.

Although some examples shall be described in terms of electroforming, the present metallic articles may alternatively be formed by other methods such as etching, stamping, assembling of wires, or machining, such as by using a laser or water jet.

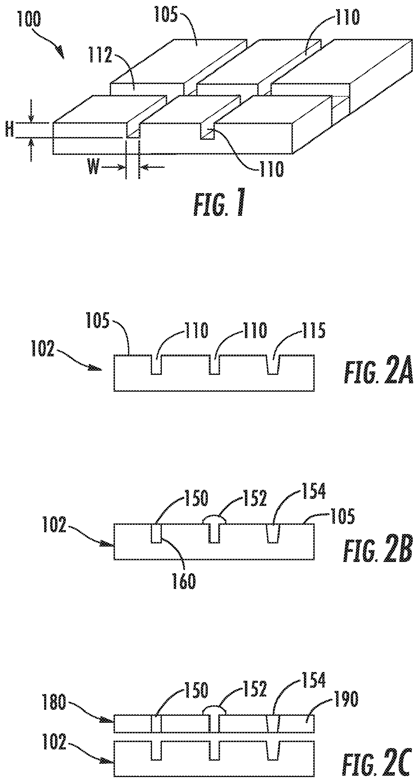

FIG. 1 depicts a perspective view of a portion of an electroforming mandrel 100 in accordance with some embodiments of U.S. Patent No. 8,916,038. The mandrel 100 may be made of electrically conductive material such as stainless steel, copper, anodized aluminum, titanium, or molybdenum, nickel, nickel-iron alloy (e.g., Invar), copper, or any combinations of these metals, and may be designed with sufficient area to allow for high plating currents and enable high throughput. The mandrel 100 has an outer surface 105 with a preformed pattern that comprises pattern elements 110 and 112 and can be customized for a desired shape of the electrical conduit element to be produced. In this example, the pattern elements 110 and 112 are grooves or trenches with a rectangular cross-section, although in other examples, the pattern elements 110 and 112 may have other cross-sectional shapes. The pattern elements 110 and 112 are depicted as intersecting segments to form a grid-type pattern, in which sets of parallel lines intersect perpendicularly to each other in this example.

The pattern elements 110 have a height 'H' and width 'W', where the height-to-width ratio defines an aspect ratio. By using the pattern elements 110 and 112 in the mandrel 100 to form a metallic article, the electroformed metallic parts can be tailored for photovoltaic applications. For example, the aspect ratio may be between about 0.01 and about 10 as desired, to meet shading constraints of a solar cell.

The aspect ratio, as well as the cross-sectional shape and longitudinal layout of the pattern elements, may be designed to meet desired specifications such as electrical current capacity, series resistance, shading losses, and cell layout. Any electroforming process can be used. For example, the metallic article may be formed by an electroplating process. In particular, because electroplating is generally an isotropic process, confining the electroplating with a pattern mandrel to customize the shape of the parts is a significant improvement for maximizing efficiency. Furthermore, although certain cross-sectional shapes may be unstable when placing them on a semiconductor surface, the customized patterns that may be produced through the use of a mandrel allows for features such as interconnecting lines to provide stability for these conduits. The preformed patterns may be configured as a continuous grid with intersecting lines. This configuration not only provides mechanical stability to the plurality of electroformed elements that form the grid, but also enables a low series resistance since the current is spread over more conduits. A grid-type structure can also increase the robustness of a cell. For example, if some portion of the grid becomes broken or non-functional, the electrical current can flow around the broken area due to the presence of the grid pattern.

FIGs. 2A-2C are simplified cross-sectional views of stages in producing a metal layer piece using a mandrel in accordance with some examples, as disclosed in U.S. Patent No. 8,916,038. In FIG. 2A, a mandrel 102 with pattern elements 110 and 115 is provided. Pattern element 115 has a vertical cross-section that is tapered, being wider toward the outer surface 105 of the mandrel 102. The tapered vertical cross-section may provide certain functional benefits, such as increasing the amount of metal to improve electrical conductivity, or aiding in removal of the electroformed piece from the mandrel 102. The mandrel 102 is subjected to an electroforming process, in which electroformed elements 150, 152 and 154 are formed within the pattern elements 110 and 115 as shown in FIG. 2B. The electroformed elements 150, 152 and 154 may be, for example, copper only, or alloys of copper. In other examples, a layer of nickel may be plated onto the mandrel 102 first, followed by copper so that the nickel provides a barrier against copper contamination of a finished semiconductor device. An additional nickel layer may optionally be plated over the top of the electroformed elements to encapsulate the copper, as depicted by nickel layer 160 on electroformed element 150 in FIG. 2B. In other examples, multiple layers may be plated within the pattern elements 110 and 115, using various metals as desired to achieve the necessary properties of the metallic article to be produced.

In FIG. 2B the electroformed elements 150 and 154 are shown as being formed flush with the outer surface 105 of mandrel 102. Electroformed element 152 illustrates another example in which the elements may be overplated. For electroformed element 152, electroplating continues until the metal extends above the outer surface 105 of mandrel 102. The overplated portion, which typically will form as a rounded top due to the isotropic nature of electroforming, may serve as a handle to facilitate the extraction of the electroformed element 152 from mandrel 102. The rounded top of electroformed element 152 may also provide optical advantages in a photovoltaic cell by, for example, being a reflective surface to aid in light collection. In yet other examples not shown, a metallic article may have portions that are formed on top of the mandrel outer surface 105, such as a bus bar, in addition to those that are formed within the preformed patterns 110 and 115.

In FIG. 2C the electroformed elements 150, 152 and 154 are removed from the mandrel 102 as a free-standing metallic article 180. Note that FIGs. 2A-2C demonstrate three different types of electroformed elements 150, 152 and 154. In various examples, the electroformed elements within the mandrel 102 may be all of the same type, or may have different combinations of electroformed patterns. The metallic article 180 may include intersecting elements 190, such as would be formed by the cross-member pattern elements 112 of FIG. 1. The intersecting elements 190 may assist in making the metallic article 180 a unitary, free-standing piece such that it may be easily transferred to other processing steps while keeping the individual electroformed elements 150, 152 and 154 aligned with each other. The additional processing steps may include coating steps for the free-standing metallic article 180 and assembly steps to incorporate it into a semiconductor device. By producing the metal layer of a semiconductor as a free-standing piece, the manufacturing yields of the overall semiconductor assembly will not be affected by the yields of the metal layer. In addition, the metal layer can be subjected to temperatures and processes separate from the other semiconductor layers. For example, the metal layer may undergo high temperature processes or chemical baths that will not affect the rest of the semiconductor assembly.

After the metallic article 180 is removed from mandrel 102 in FIG. 2C, the mandrel 102 may be reused to produce additional parts. Being able to reuse the mandrel 102 provides a significant cost reduction compared to current techniques where electroplating is performed directly on a solar cell. In direct electroplating methods, masks or mandrels are formed on the cell itself, and thus must be built and often destroyed on every cell. Having a reusable mandrel reduces processing steps and saves cost compared to techniques that require patterning and then plating a semiconductor device. In other conventional methods, a thin printed seed layer is applied to a semiconductor surface to begin the plating process. However, seed layer methods result in low throughputs. In contrast, reusable mandrel methods as described herein can utilize mandrels of thick metal which allow for high current capability, resulting in high plating currents and thus high throughputs. Metal mandrel thicknesses may be, for example, between 0.2 to 5 mm.

Metallic articles fabricated by an electroforming mandrel enable features to be tailored even further to meet desired functional and manufacturing needs of a particular photovoltaic cell, such as is disclosed in U.S. Patent No. 8,936,709, owned by the assignee of the present application. For example, individual shapes of elements within the metallic article can be custom-designed, or elements in one region of the metallic article can be designed with features geometrically different from elements in another region. The customized features may be used individually or in combination with each other. The use of an electroforming mandrel decouples dimensional constraints of the overall electroformed piece so that the features may be optimized for a particular area within the metallic article. Furthermore, the metallic articles produced by the electroforming methods enable tailoring for a particular type of cell, such as lower-cost residential versus high-efficiency cells. Features of the metallic articles also allow for integration of interconnection components, so that solar cells that utilize the metallic articles as electrical conduits are module-ready. The metallization provided by the metallic articles provide a higher metallization volume and lower resistance than traditional cell metallizations with the same footprint, while reducing cost compared to silver-based and ribbon-based metallization. The metallic articles also facilitate light-weight and sag-tolerant photovoltaic cells designs.

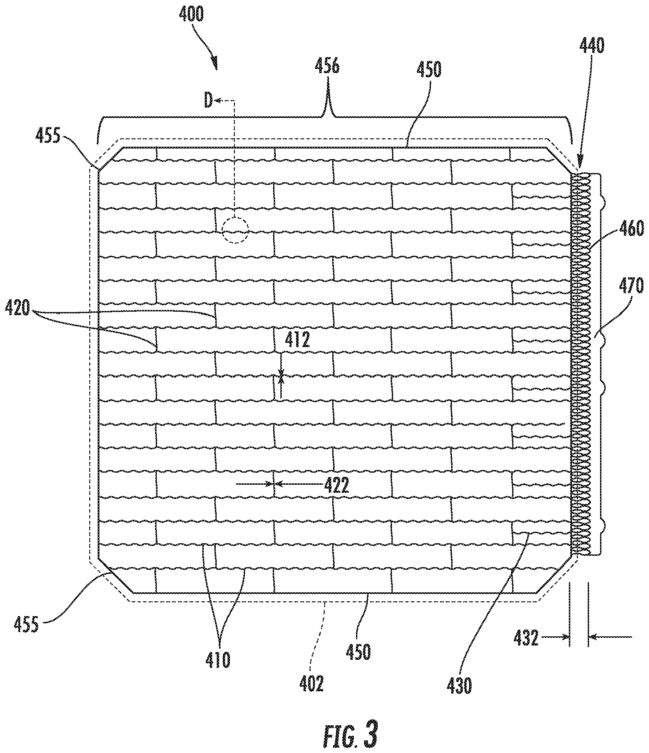

FIG. 3 shows a top view of a metallic article 400 of the present disclosure in accordance with some examples of various features adapted for a photovoltaic cell. A semiconductor substrate 402 is shown in dashed lines to demonstrate the placement of metallic article on a photovoltaic cell, where the metallic article 400 is configured here as a grid for the front side of the cell. However, the features described herein may be applied to an electrical conduit for the back side of a photovoltaic cell. In this disclosure, reference to semiconductor materials in formation of a semiconductor device or photovoltaic cell may include amorphous silicon, crystalline silicon or any other semiconductor material suitable for use in a photovoltaic cell. The metallic articles may be also applied to other types of semiconductor devices other than photovoltaic cells. Semiconductor substrate 402 is shown in FIG. 3 as a mono-crystalline cell with rounded corners, also referred to as a pseudosquare shape. In other examples, the semiconductor substrate may be multi-crystalline, with a fully square shape. Semiconductor substrate 402 may have electrical conduit lines (not shown) on its surface, such as silver fingers, that carry current generated by substrate 402.

The metallic article 400 includes a first region 456 having a plurality of electroformed elements that are configured to serve as an electrical conduit for a light-incident surface of the photovoltaic cell. A cell-to-cell interconnect 440 is integral with the first region 456. Silver fingers may be screen-printed onto the semiconductor substrate 402 according to conventional methods. For example, the silver fingers may be lines that are perpendicular to the direction of grid lines 410 in the first region 456. The elements of metallic article 400 then serve as electrical conduits to carry electrical current from the silver fingers. In this example of FIG. 3, grid lines 410 (in the horizontal direction in FIG. 3) and segments 420 (in the vertical direction in FIG. 3) in the first region 456 of metallic article 400 are electrically coupled to the semiconductor substrate 402, such as by soldering, to collect and deliver the current to the interconnection element or cell-to-cell interconnect 440. Grid lines 410 may be perpendicular to the edge of the first region 456. Cell-to-cell interconnect 440 enables cell-to-cell connections for a solar module to create a solar array. Fabricating metallic article 400 with a metal such as copper reduces the cost compared to a cell in which silver is used for all the electrical conduits, and can also improve cell efficiency due to improved conductivity.

The plurality of electroformed elements may comprise a plurality of first elements intersecting a plurality of second elements. For example, the grid lines 410 and segments 420 of FIG. 3 are shown as intersecting and approximately perpendicular to each other; however, in other examples they may be at non-perpendicular angles to each other. Although both the grid lines 410 and segments 420 are capable of carrying electrical current, grid lines 410 provide the path of least resistance to cell-to-cell interconnect 440 and would function as the primary carriers of electrical current. Segments 420 provide mechanical support for the free-standing metallic article 400, both in terms of strength and in maintaining dimensional specifications of the grid. However, segments 420 can also serve as electrical conduits, such as in providing redundancy if grid lines 410 should fail. Grid lines 410 and segments 420 may have widths 412 and 422, respectively, that differ from each other such as to optimize mechanical strength or achieve a desired fill factor for the cell. For example, width 412 of grid lines 410 may be smaller than width 422 of segments 420, so that segments 420 provide sufficient mechanical stability for metallic article 400 while grid lines 410 are tailored to achieve as high a fill factor as possible. In further examples, certain grid lines 410 may have different widths than other grid lines 410, such as to address mechanical strength or electrical capacity of a particular zone. The pitch of grid lines 410 may also vary from the segments 420, or may vary from each other in different regions within metallic article 400 to meet required device conduction requirements. A coarser or finer mesh pitch may be chosen based on, for example, the silver finger designs of the wafer, the precision of the silver screen printing process, or the type of cell being used.

In another example, the pattern of the elements in the first region 456 to collect and deliver the current to an interconnection element of metallic article 400 may consist of grid lines (in the horizontal direction) and grid lines (in the vertical direction) which are electrically coupled to the semiconductor substrate 402. The grid lines in the vertical direction may differ from the segments 420 in FIG. 3 in that the grid lines in the vertical direction run from one edge member 450 of the metallic article 400 to the other edge member 450 of the metallic article 400 and are substantially perpendicular to the horizontal grid lines. The horizontal grid lines and the vertical grid lines form a mesh configuration.

Further features that may be tailored may be designed into the electroforming mandrel in which the metallic article is fabricated. For example, the metallic article may have intersecting grid lines forming a mesh configuration over the majority of the first region 456 of the metallic article. The grid lines may have a width that is non-uniform along its length. In some examples, the width of the horizontal grid line is wider nearer the interconnect element (or cell-to-cell interconnect 440), which is the current collection end of the cell. This increased width accommodates the higher electrical current at this end, as current is gathered by the metallic article across its surface of the first region 456. Thus, the increased width reduces resistive losses. The height of the grid line may also be adjusted as desired in the areas of increased width.

Moreover, the lengthwise profile may be altered in shape in addition to varying in width. The horizontal and vertical grid lines may be configured with a non-linear pattern that allows the grid lines to expand lengthwise, thus serving as an expansion segment. In some examples, the both the horizontal and vertical grid lines may have a wave-type pattern, as exemplified by grid lines 410 and segments 420. The wave pattern may be configured as, for example, a sine-wave or other curved shape or geometries. The wave pattern may provide extra length between solder points to allow the metallic article to expand and contract, such as to provide strain relief for differences in coefficients of thermal expansion (CTE) between metallic article and the semiconductor substrate to which it is joined. For example, a copper has a CTE of around five times that of silicon. Thus, a copper metallic article soldered to a silicon substrate will experience significant strain during heating and cooling steps involved with manufacturing the sub-assembly into a finished solar cell. In other examples only certain grid lines may be configured as expansion segments. In yet further examples, only a certain portion of a single grid line may be configured as an expansion segment, while the remainder of the length is linear.

In the example of FIG. 3, the grid lines 410 have a wave-type pattern. Also, the segments 420 have a wave-type pattern. Near the cell-to-cell interconnect 440, additional horizontal sections 430 may be present. The additional horizontal sections 430 provide additional current carrying capability. In other examples, the grid lines 410 and segments 420 may be linear or be a combination of wave-type pattern and linear. Grid lines 410 and segments 420 also include edge members 450 and 455, which are configured to be located near the perimeter of a solar cell. For instance, the edge members 450 and 455 may be located 1-3 mm from the edges of the wafer. Because edge members 450 and 455 form the perimeter of metallic article 400, edge members 450 and 455 may be wider than other grid lines 410 and segments 420 in the interior of metallic article 400, to provide additional structural support. Edge members 455 are configured as corner bus bars in the example of FIG. 3, that form an angle from the main edge member 450. That is, edge member 450 has a change in conduit direction along the length, such as to accommodate a pseudosquare shape in this example. This change in direction can be integrally formed by the electroforming mandrel, and can include tailoring the width of the corner bus bar 455 for improving mechanical strength and reducing resistive losses. Wider bus bars 450 and 455 at the perimeter of metallic article 400 can also improve the bonding strength when attaching the metallic article 400 to the semiconductor substrate 402.

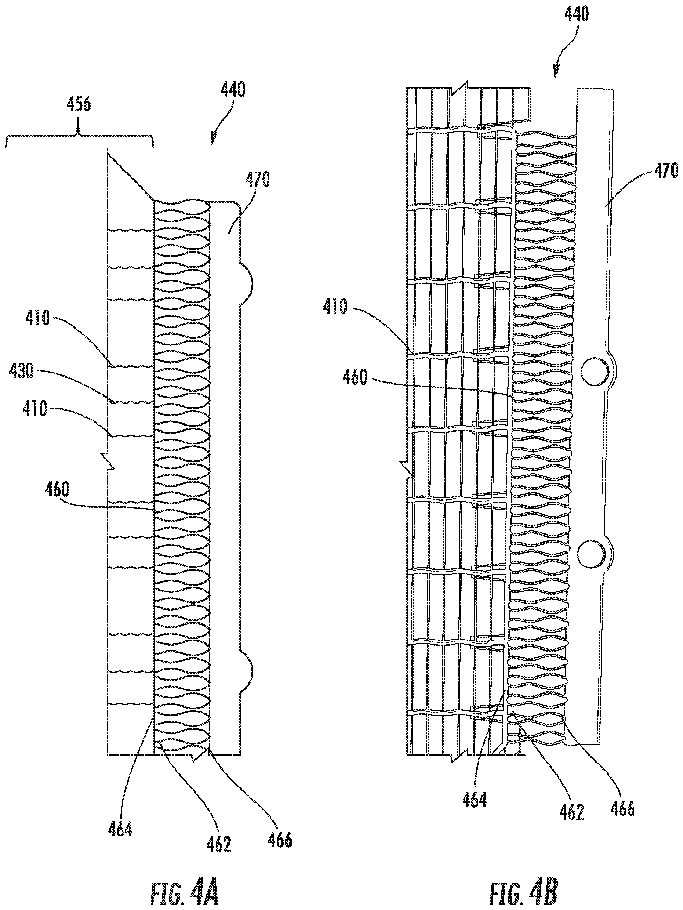

Cell-to-cell interconnect 440 is near an edge of the metallic article 400. The cell-to-cell interconnect 440 is integral with the first region 456. The cell-to-cell interconnect 440 is configured to extend beyond the light-incident surface of the first region 456 and to directly couple the metallic article 400 to a neighboring photovoltaic cell. FIGs. 4A and 4B are a close-up view of a cell-to-cell interconnect in accordance with some examples. The cell-to-cell interconnect 440 includes a plurality of electroformed, appendages 460. Each appendage 460 has a first end 462 coupled to an edge 464 of the first region 456 and a second end 466 opposite the first end 462 and away from the edge 464. That is, the second end 466 is coupled to a metallic strip 470 of cell-to-cell interconnect 440. The appendages 460 are spaced apart from each other. By having neighboring appendages 460 spaced apart - that is, not joined together - stress relief is improved due to the independent flexion and thermal expandability of each appendage.

In some examples, each appendage 460 traverses a non-perpendicular path between the edge 464 of the first region 456 and the metallic strip 470. The pattern of appendages 460 form an outline of an hourglass or bowling pin shape comprised of curved surfaces within the original plane of the cell-to-cell interconnect 440, with little to no sharp or straight edges or angles. Other shapes of appendages 460 may be used such as symmetric or asymmetric; sinusoidal wave-like shapes such as S-shaped, U-shaped, W-shaped, V-shaped, serpentine shaped, saw-tooth shaped; L-shaped or other curved or linearly bent configurations. The choice of shape depends on the application in which the photovoltaic cell is to be used, such as the amount of mechanical flexing and temperature variation to which the cell will be exposed. For example, an increased number or amplitude of curves (or bends) along the appendage can be chosen for higher mechanical and thermal stress environments.

The curvature of the appendages 460 may be larger at the first end 462 or the second end 466, compared to the other end. The appendages 460 may be spaced apart from each other and the pattern of the appendages 460 may be repeated one after another in a head-to-tail fashion or in a head-to-head way. The appendages 460 may have a repeating or non-repeating pattern across the cell-to-cell interconnect 440. The appendages 460 enable lateral compliance and a spring-like structure for strain relief due to mechanical and thermal stresses.

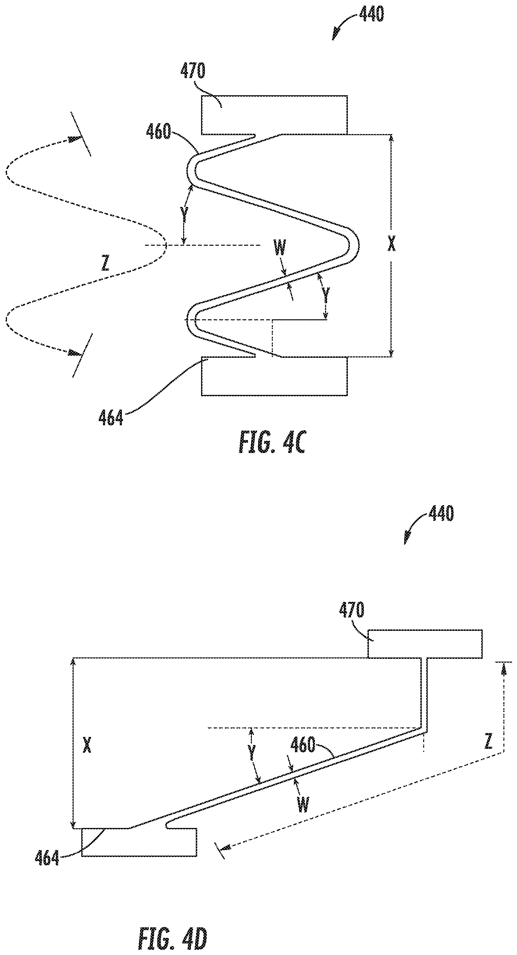

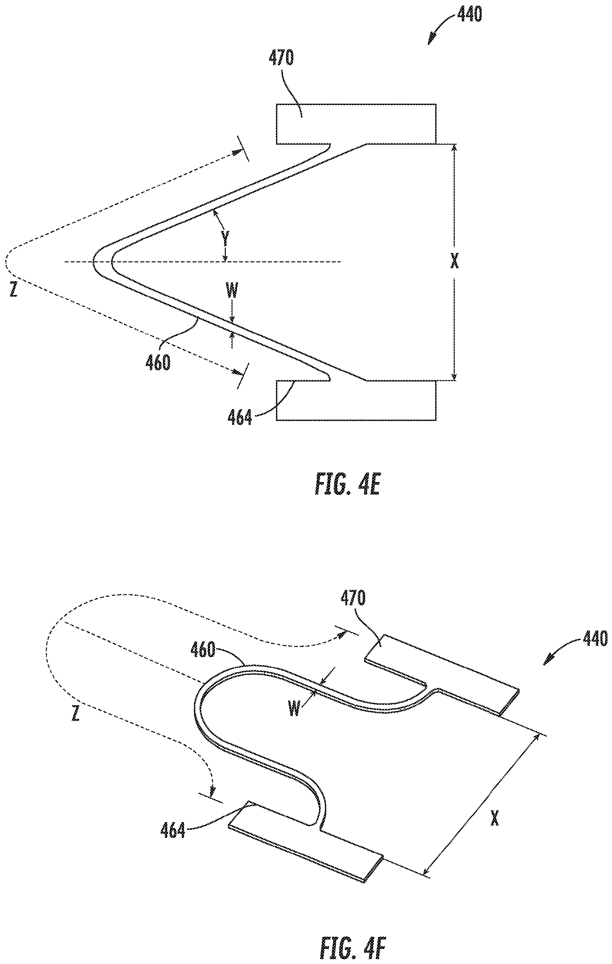

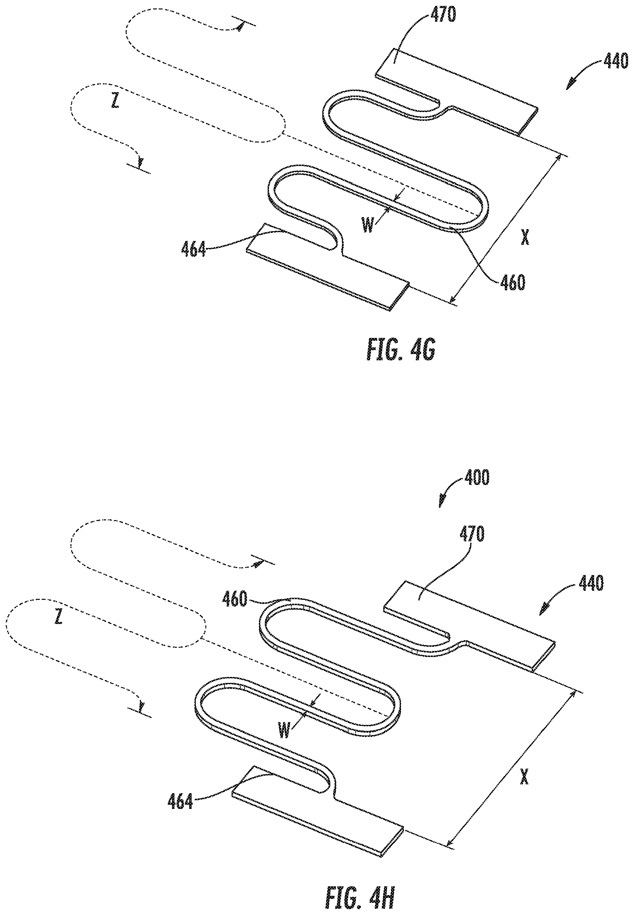

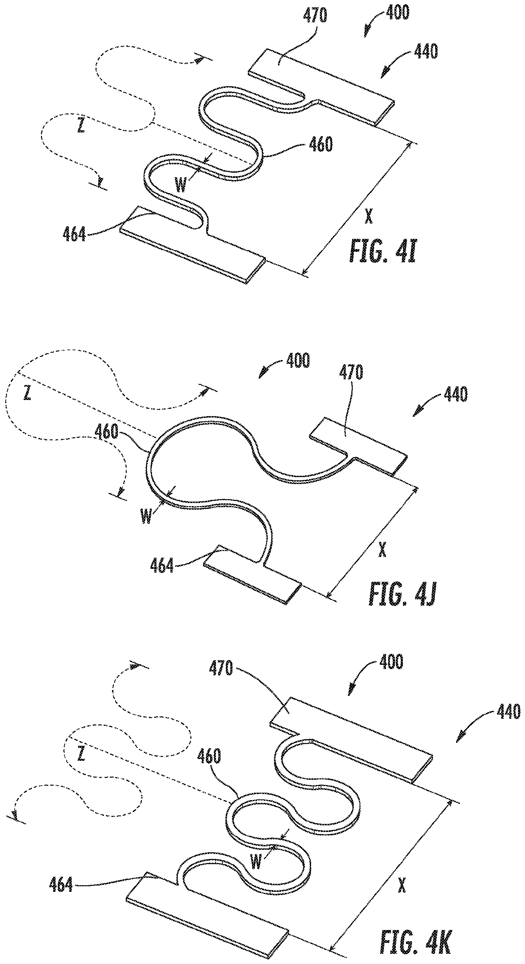

FIGs. 4C-4K depict a partial view of the cell interconnect 440 with various shapes of appendages in accordance with some examples. For example, FIG. 4C has a W-shaped appendage, FIG. 4D has a L-shaped appendage, FIG. 4E has a V-shaped appendage, FIG. 4F has a U-shaped appendage and FIG. 4G has a serpentine shaped appendage with three U-shaped curves. FIGs. 4H and 4I are similar to FIG. 4G but with different amplitude curves of the appendage than as shown in FIG. 4G. FIG. 4J has a S-shaped appendage and FIG. 4K has a serpentine shaped appendage with three S-shaped curves.

The designs illustrated in FIGs. 4C, 4D and 4E show sample dimensions of the appendages 460. The appendage 460 spans the distance between the edge 464 of the first region 456 and the metallic strip 470, labeled as a distance "X" on FIG. 4C. The orthogonal distance X between edge 464 of the first region 456 and metallic strip 470 to be designed into metallic article 400 will depend on factors such as the gap between solar cells when assembled in a module, and the amount of flexing that the module is designed to endure. For example, the distance X may be 4-10 mm, such as 6 mm. In some examples, the length of the appendage 460, along the path of the appendage material (path "Z" in FIG. 4C), is greater than 1.4 times the distance X between the edge 464 of the first region 456 and the metallic strip 470. In one example where X is 6 mm, the appendage length Z is at least 1.4 x 6 mm = 8.4 mm. In other examples, the appendage length of the appendage 460 is up to 3 times the distance between the edge 464 of the first region 456 and the metallic strip 470. In further examples, the appendage length of the appendage 460 is at least 1.5 to 2 times the distance X - that is, the distance between the edge 464 of the first region 456 and the metallic strip 470.

In some examples, in a plan view, the width "W" of the appendage 460 may be at least 80 µm to 350 µm. The width of the appendages 460 will depend on the total number of appendages 460 and the electrical current capacity of the photovoltaic cell that must be carried by the appendages 460. Depending on the shape of the appendage 460, the width of the appendage 460 may vary along the shape. For example, in FIG. 4E, the width of the appendage 460 is 190 µm in some portions and 300 µm in other portions such as in the radius sections. In other examples, in a plan view, the width of the appendage 460 is constant throughout. For example, in FIGs. 4F and 4H, the width of the appendage 460 is 200 µm throughout the entire shape. In some examples, the thickness of the appendage 460 is at least 90 µm and less than 150 µm.

A tangent angle of the appendage 460 with respect to the horizontal edge 464 of the first region 456 may be calculated and defined as Y in FIG. 4C. Larger tangent angles may result in a shape of the appendage 460 that enables more dense nesting and packing of the appendages 460 close to one another. The greater the number of appendages 460 that can be incorporated into the cell-to-cell interconnect 440, the greater the possible amount of electrical current flow between metallic articles 400 while minimizing electrical resistance. For example, in FIG. 4C, the angle between any tangent to the appendage and a horizontal edge of the first region is angle Y = 18°; in FIG. 4D, the angle Y = 19°; in FIG. 4E, the angle Y = 23.2°. In some examples, the angle between the tangent of the appendage 460 and the horizontal edge 464 of the first region 456 is at least 12°. In other examples, the angle is less than 75°.

The designs illustrated in FIGs. 4F-4K show shapes of the appendage 460 with the tangent angle Y being very small, such as 0°. Because of the geometry of theses shapes, the appendages 460 do not nest as closely per centimeter but may enable the appendages 460 to have more flexibility, springiness and durability due to the increased appendage length Z compared to the shapes depicted in FIGs. 4C-4E, while still providing sufficient electrical properties. When designing the shape of the appendage 460, there is a trade-off between mechanical and electrical properties; that is, mechanical flexibility/durability of the appendages 460 and densely packing the appendages 460 along the cell-to-cell interconnect to enable less electrical resistance and more current flow between the photovoltaic.

The use of a particular appendage shape, such as those shown in FIGs. 4A-4K, will depend on the specifications for which the photovoltaic module is being designed. For example, the amount and direction of mechanical deflection, and the amount of thermal expansion and contraction will affect the appendage length Z that is needed to accommodate the stresses on the metallic article 400. In another example, the amount of torsional stresses on a photovoltaic module can affect the choice of radius used in the curves of an appendage. In general, the greater the amount of expansion and/or flexing, the greater the appendage length Z is desired to serve as a spring element to accommodate these stresses. Also, the greater the electrical current capacity of the module, the greater the amount of material in the appendages is desired - as provided by the number of appendages and/or the width of the appendages -for carrying the electrical current.

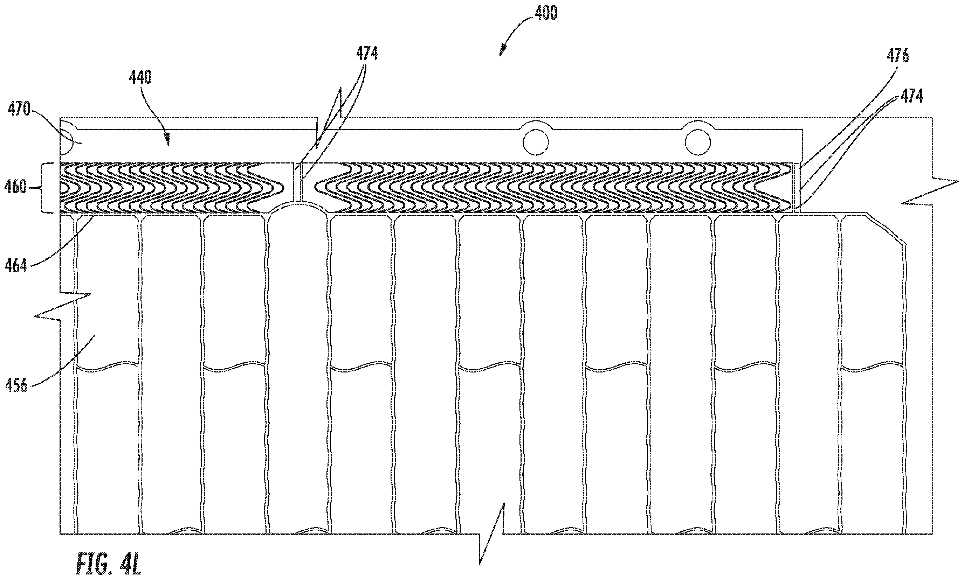

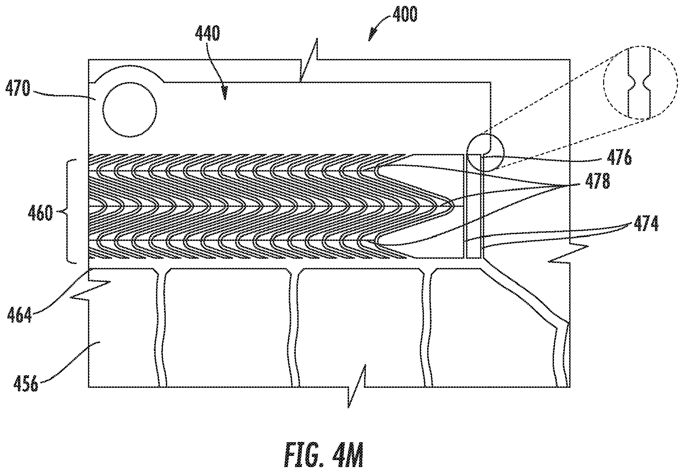

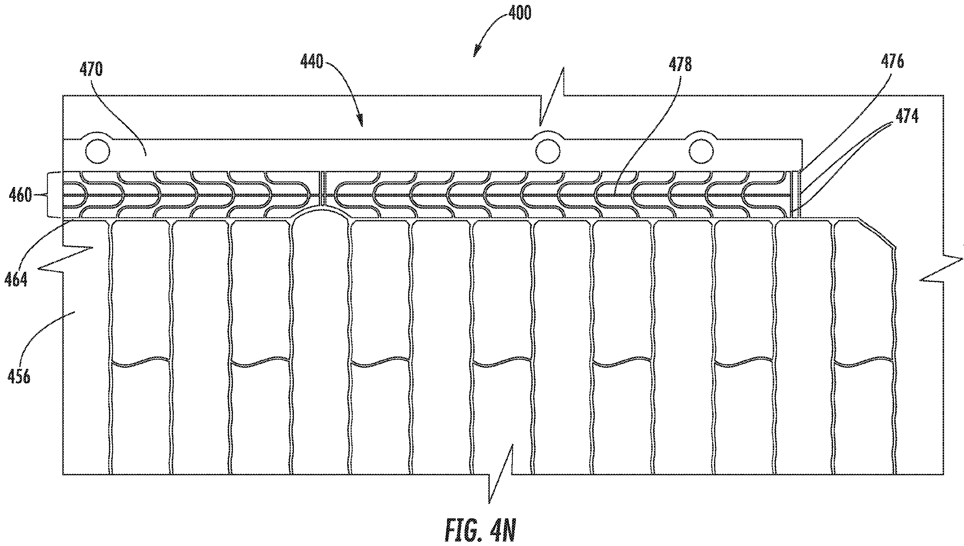

FIGs. 4L-4N show the cell-to-cell interconnect 440 in accordance with some examples, showing the nesting of appendages and additional features for improving durability of the metallic article. FIG. 4L illustrates a W-shaped appendage 460 of the cell-to-cell interconnect 440, where FIG. 4M illustrates a close-up view of FIG. 4L. FIG. 4N illustrates a U-shaped appendage 460 of the cell-to-cell interconnect 440. The appendages 460 are configured to nest with one appendage 460 fitting at least partially into the space of another appendage 460, maximizing the number of appendages 460 positioned in a particular length, width or distance. In some examples, the appendages 460 may be repeated at least 8 times per centimeter, at least 10 per centimeter, or at least 12 per centimeter. When comparing FIG. 4M to FIG. 4N, the W-shaped appendages 460 of FIG. 4M are much more densely packed per centimeter than the U-shaped appendages 460 of FIG. 4N. For example, the W-shaped appendages 460 have a tangent angle Y as discussed in FIG. 4C of approximately 18° while the U-shaped appendages 460 have a tangent angle Y of practically 0°. With the tangent angle Y being very small, or less than 12°, it is difficult to closely nest the appendages 460 together as illustrated when comparing FIG. 4M to FIG. 4N.

FIGs. 4L-4N show a further feature that may be used to improve durability and manufacturability of the metallic articles, where the cell-to-cell interconnects 440 have one or more links 474. Each link 474 has a first link end coupled to an edge 464 of the first region 456 and a second link end opposite the first link end and away from the edge 464 of the first region 456. The second link end is coupled to the metallic strip 470. The link 474 is linear and is perpendicular to the edge of the first region 456. In some examples, the appendage length is greater than the length of the link 474. In some examples, the length of the link is the distance X - that is, the distance between the edge 464 of the first region 456 and the metallic strip 470.

Each link 474 has a neck 476 which is tapered and narrower in width than the width of the link 474, to provide a designated breakage point for the link 474. The neck 476 is illustrated at the second link end of the link 474 in these examples, such that the tapered neck is along a length of the link, but the neck 476 may be located anywhere along the link 474 as desired. In some examples, in a plan view, the width of the link 474 is less than 200 µm and the neck 476 is less than 50 µm. In a plan view, the width of the neck 476 is at least 1.5 times thinner than the width of the link 474.

The links 474 provide stability to the metallic article 400, absorb forces and prevent breakage from forces, such as tension or torque, being applied to the appendages 460 during manufacture. For example, when the metallic article 400 is removed from an electroforming mandrel, typically by separating, lifting or peeling, the links 474 provide stability to the metallic article 400 and prevent the plurality of appendages 460 from stretching or breakage. The removal process is described in some examples of U.S. Patent No. 8,916,038. The links 474 also provide stability when manufacturing the metallic article using other methods (e.g., stamping), or when handling the free-standing metallic article prior to the article being bonded onto a solar cell.

Referring to FIG. 4M, the neck 476 at the second end of the link 474 is tapered and narrower than the rest of the link 474 and is a weaker section of the cell-to-cell interconnect 440 where breakage, if necessary, is designed to occur in a controlled fashion. The cell-to-cell interconnect 440 is designed to break at the neck 476 of the link 474 when a force is applied to the cell-to-cell interconnect 440. The neck 476 of the link 474 is designed to break at a force that is less than a breaking strength of the appendages 460. The link 474 serves to prevent stresses on the appendages 460 while the metallic article 400 is being handled during manufacturing. However, once the metallic article 400 has been assembled into a solar module, it is not necessary for the link 474 to remain intact, since the appendages 460 provide the operative flexing region of the cell-to-cell interconnect 440. If breakage occurs in the links 474, the electrical conductance between the appendages 460 and the metallic strip 470 will be only slightly reduced since the links 474 are few in number compared to the appendages 460. For example, the solar module array may be subjected to shock and vibration during transportation or while in service due to thermal cycling and may experience mechanical stress. The cell-to-cell interconnect 440 with the plurality of the appendages 460 improve the natural in-plane and out-of-plane inflexibility or rigidness between adjacent solar cells because the appendages 460 may act as soft, flexible springs which conduct electrical current and do not crack or break during transportation, installation and normal thermal cycling.

The examples of FIGs. 4L-4N depict two links 474 at one end of the row of appendages 460, two links 474 in the middle of the row, and two links 474 at an opposite end (not shown). Other configurations are possible, such as one link at each location, or one or more links 474 at various locations along the row of appendages 460, or just a single link 474 for the entire row (e.g., one link 474 placed in the middle of the row).

In some examples, the cell-to-cell interconnect 440 may have one or more crossbars 478 extending across the appendages 460 and connecting one appendage 460 to a neighboring appendage 460. Referring to FIGs. 4M and 4N, the crossbars 478 are positioned horizontally between the appendages 460 and additionally, between the appendage 460 and link 474. Optionally, the crossbars 478 may be positioned between the links 474. The crossbars 478 provide stability to the metallic article 400 such as to prevent the appendages from being damaged during the separation of the metallic article 400 from the mandrel 100, and to enable the appendages 460 to flex and move in unison while still preserving the overall springiness of the appendages 460. There may be one row of crossbars 478 such as shown in FIG. 4N or a plurality of rows of crossbars 478 such as shown in FIG. 4M. The placement of the crossbars 478 relative to the appendages may be uniform or random. In the examples of FIGs. 4M and 4N, the crossbars 478 are placed at the peaks of the curves in the appendages 460, where damage due to mishandling is most likely to occur.

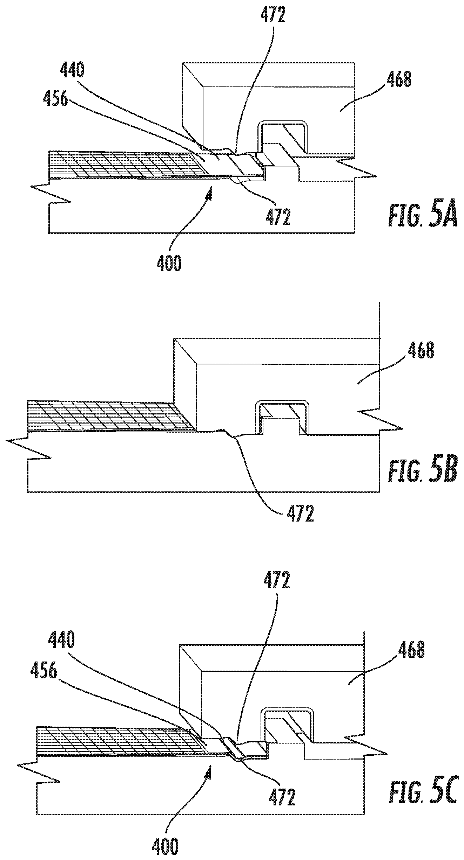

The metallic article 400, including the first region 456 and the cell-to-cell interconnect 440, may be electroformed on an electrically conductive mandrel and formed by a preformed pattern to form a unitary, free-standing piece when separated from the electrically conductive mandrel. In some examples, the cell-to-cell interconnect 440 of the metallic article 400 may be formed in plane with the first region 456. In other examples, the cell-to-cell interconnect 440 of the metallic article 400 may be manipulated to create a bend or angle out of the plane of the first region 456. FIGs. 5A-5C depict a method of processing for the metallic article 400 in accordance with some examples. For example, FIG. 5A shows the metallic article 400 including the first region 456 and the cell-to-cell interconnect 440, placed in a fixture 468. The fixture 468 may be a forming press that changes the shape of a workpiece by the application of pressure such as by a hydraulic, mechanical or pneumatic mechanism. The top and bottom portions of the fixture 468 may be preformed with the pattern or a die may be used so that when the press is closed, pressure is applied deforming the workpiece into the preformed shape. In FIGs. 5A-5C, an S-shaped bend 472 is provided in the fixture 468, to form a corresponding bend shape in the cell-to-cell interconnect 440. FIG. 5B demonstrates the fixture 468 in the closed positon applying pressure to the metallic article 400. FIG. 5C is the fixture 468 in the open position showing the new shape of the metallic article 400.

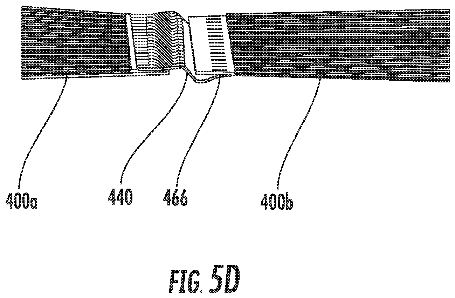

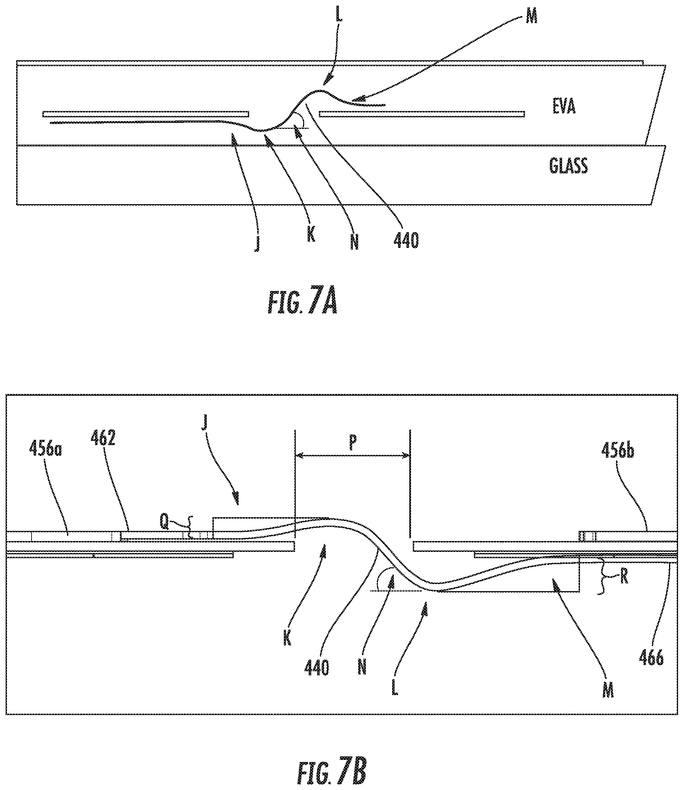

FIG. 5D depicts two metallic articles 400a and 400b in which 400a is after formation by fixture 468 in accordance with some examples. Metallic article 400a may be configured for a front surface of a photovoltaic cell, while metallic article 400b is for a back surface. Metallic article 400a is coupled to metallic article 400b via cell-to-cell interconnect 440, where the bend in the direction perpendicular to the cell plane facilitates the front-to-back connect. The first region 456 of metallic article 400 may comprise a first plane and the cell-to-cell interconnect 440 may comprise a bend that places the second ends 466 of the plurality of electroformed appendages 460 in a second plane different from the first plane. In some examples, the bend may be configured at an angle of 5° to 85° relative to the plane of the metallic article (see angle N, FIGs. 7A-7B).

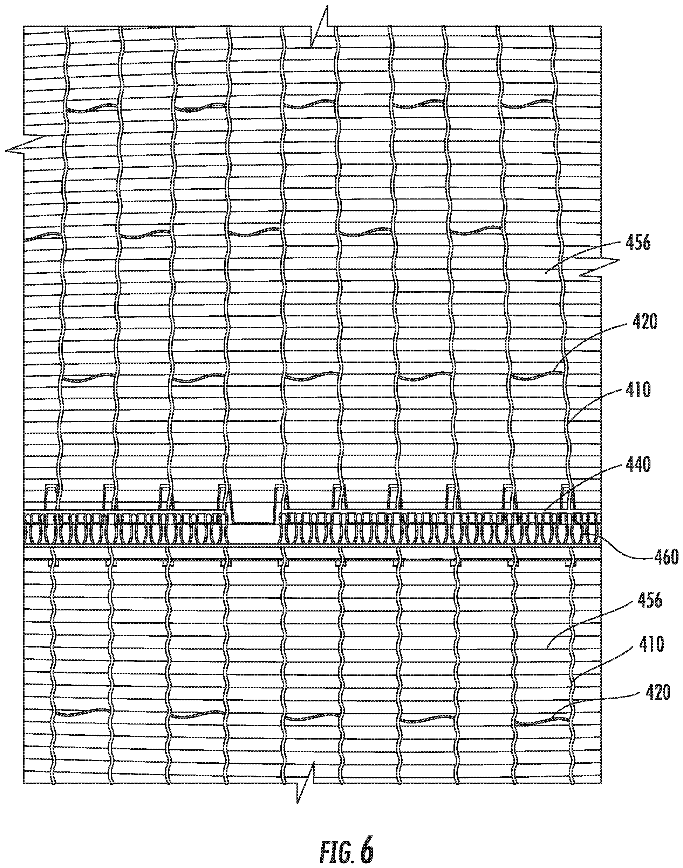

The cell-to-cell interconnect 440 is configured to extend beyond the light-incident surface and to directly couple the metallic article 400 to a neighboring photovoltaic cell. For example, the cell-to-cell interconnect 440 may be coupled to the front side of the photovoltaic cell and the back side of a neighboring photovoltaic cell when the photovoltaic cell and the second photovoltaic cell are adjacent. This enables current to flow between the metallic article 400 and the second metallic article. FIG. 6 illustrates a top view of the cell-to-cell interconnect 440 coupled to the front side of one photovoltaic cell and the back side of a neighboring photovoltaic cell in accordance with some examples.

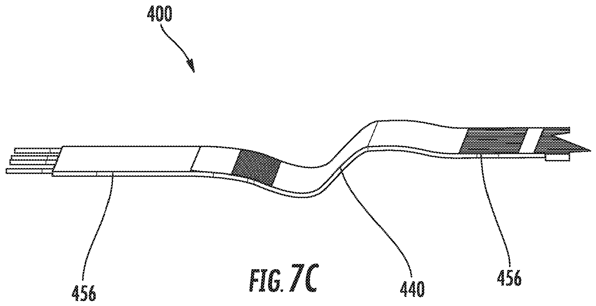

When the cell-to-cell interconnect 440 is coupled to the front side of the photovoltaic cell and the back side of a second photovoltaic cell, the electroformed appendage 460 is configured to protrude or bulge out of plane with the photovoltaic cell and out of plane with the second photovoltaic cell. FIGs. 7A-7C illustrate side views of the cell-to-cell interconnect 440 between two adjacent photovoltaic cells in accordance with some examples. FIG. 7A provides a simplified side view of interconnected cells assembled within a solar module; FIG. 7B provides a side view of interconnected solar cells, and FIG. 7C shows a perspective view of interconnected metallic articles. In FIG. 7A, tight curves are avoided to maximize the strain relief aspect in the design. Arrows K and L indicate the protrusions of the cell-to-cell interconnect 440, which are out of plane with the photovoltaic cell and out of plane with the second photovoltaic cell when mounted between adjacent photovoltaic cells. Arrows J and M indicate slight curves of the cell-to-cell interconnect 440 before coupling to the first region 456 of the metallic article 400. The angle N indicates a bend angle which may be, for example, 5° to 85°.

FIG. 7B is the cell-to-cell interconnect 440 in accordance with some examples. Two adjacent photovoltaic cells, each with a first region 456 are positioned at a distance P which may be, for example, approximately 1.0 mm to 3.0 mm apart, or in this example, 2.0 mm apart. In some examples, the length of the appendages 460 is at least 4 times the gap distance between adjacent photovoltaic cells. For example, if the adjacent photovoltaic cells are positioned at a distance P which is 2.0 mm, then the length of the appendages 460 is 4 x 2.0 mm = 8.0 mm. This is applicable to when the first region 456 and the cell-to-cell interconnect 440 are located in the same plane or when the cell-to-cell interconnect 440 comprises a bend that places the second ends 466 of the plurality of appendages 460 in a second plane different from the first plane.

The first end 462 of the appendage 460 of the cell-to-cell interconnect 440 is in plane with the first region 456 of the first photovoltaic cell. Because of the formation of the bend N of the cell-to-cell interconnect 440 and the mounting of the cell-to-cell interconnect 440 between two adjacent photovoltaic cells, a first protrusion indicated by Arrow K is vertically out of plane by a height Q, such as approximately 0.2 mm to 0.4 mm, or in this example, 0.3 mm from the first region 456a of the first photovoltaic cell. The second end 466 of the appendage 460 of the cell-to-cell interconnect 440 is in plane with the first region 456b of the second photovoltaic cell. Arrow L indicates a second protrusion of the cell-to-cell interconnect 440. In this case, the second protrusion is vertically out of plane by a height R, such as approximately 0.3 mm to 0.6 mm, or in this example, 0.5 mm from the first region 456b of the second photovoltaic cell. The first protrusion and second protrusion may be vertically out of plane by different heights in order to maximize the durability of the interconnect.

FIG. 7C depicts a perspective view of the cell-to-cell interconnect 440 between two adjacent metallic articles. The first protrusion and the second protrusion in each appendage 460 of the cell-to-cell interconnect 440, provides stress relieving bends in the metallic article 400. The flexibility of the cell-to-cell interconnect 440 between photovoltaic cells alleviates issues of breakage or warping during transportation, installation or normal thermal cycling. Traditional three bus bar interconnects often cause warpage to the photovoltaic cell due to their natural inflexibility between cells.

In some examples, the metallic article 400 further comprises a metallic strip 470 integral with the cell-to-cell interconnect 440 and coupled to the second ends 466 of the plurality of electroformed appendages 460. The metallic strip 470 is configured to be coupled to a back side of the neighboring photovoltaic cell. The metallic strip 470 of the cell-to-cell interconnect 440 serves as a solder pad for the back of an adjacent cell, while the appendages 460 serve as electrical conduits between solar cells. Note that the cell-to-cell interconnect 440 design has a large surface area compared to conventional solder ribbon, in which three bus ribbons are used. Consequently, the design of cell-to-cell interconnect 440 improves efficiency at the module level by providing low series resistance and minimal voltage drop. For example, the width 432 of the cell-to-cell interconnect 440 may be 5-10 mm, such as 6-8 mm, compared to a width of 50-100 µm for grid lines 410 and segments 420.

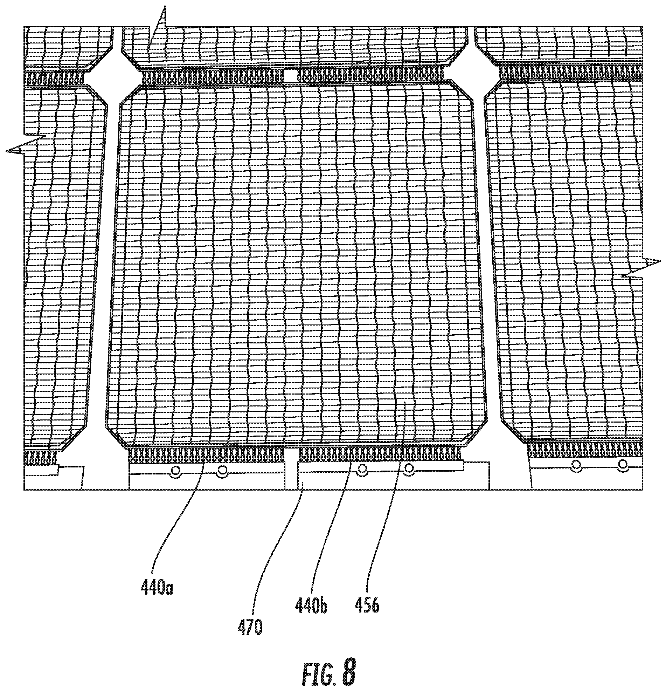

The length of cell-to-cell interconnect 440 may approximate the edge length of a photovoltaic cell, such as the entire edge of a multi-crystalline cell or the length between corners of a mono-crystalline cell. In another example, the cell-to-cell interconnect 440 may span at least one quarter of the edge of the first region 456 of the photovoltaic cell. In further examples, the cell-to-cell interconnect 440 may span nonconsecutive portions of the approximate edge length of a photovoltaic cell. FIG. 8 illustrates a perspective view of the metallic article 400 as part of the photovoltaic cell in accordance with some examples. In this example, the cell-to-cell interconnect 440 spans nonconsecutive portions 440a and 440b of the edge length of a photovoltaic cell. In further examples, the cell-to-cell interconnect 440 may span nonconsecutive or consecutive portions of the edge entire length of a photovoltaic cell or the partial edge length of the photovoltaic cell. The metallic strip 470 spans the entire length of the photovoltaic cell. In another example, the metallic strip 470 may span the length of the cell-to-cell interconnect 440. By spanning at least one quarter of the edge of the first region 456 of the photovoltaic cell, there are a plurality of current paths between adjacent cells in the solar module enhancing the redundancy over conventional three bus bar configurations. This alleviates the issue of the photovoltaic cell losing efficiency due to interconnection failures as is common with three bus bar configurations.

The cell-to-cell interconnect 440 may also serve as a manufacturing aid for removing the metallic article 400 from the electroforming mandrel. As discussed herein, the cell-to-cell interconnect 440 may be bent or angled after electroforming, such as to enable a front-to-back connection between cells. The cell-to-cell interconnect 440 may be formed integrally with the grid lines 410 and segments 420, which can reduce manufacturing cost by eliminating joining steps. In other examples, the cell-to-cell interconnect 440 may be formed as a separate piece and then joined to the first region 456, such as to allow for interchangeability of interconnection elements with different grid designs.

The cell-to-cell interconnect 440 may have a height - that is, a thickness - that may be different from the rest of metallic article 400. The thickness of the cell-to-cell interconnect 440 may comprise a height that is different from a height of the plurality of electroformed elements. In some examples, the cell-to-cell interconnect 440 may have a height of 80-100 µm while the grid lines 410 may have a thickness or height of 100-200 µm, such as 100-150 µm. Because the cell-to-cell interconnect 440 provide the mechanical, as well as electrical connections between cells in a module, the height may be tailored with a specific thickness to meet specified flex-testing requirements. A thinner cell-to-cell interconnect 440 may improve resistance to fatigue failure - such as flexing during transportation and exposure to environmental forces - while minimizing voltage loss by providing a large surface area for current flow.

The metallic article with the cell-to-cell interconnect described herein was subjected to a flexation cycle test. The flexation cycle test stresses the sample in both the x and y axis whereby x is the length of the movement between cells and y is the width of the movement. The results showed an improvement to 'mean time to failure' or fatigue of the cell-to-cell interconnect in excess of 20 times greater than that of control samples of a conventional three bus bar design. Therefore, the metallic article with the cell-to-cell interconnect with multiple appendages and the bend, improved the natural in-plane inflexibility or rigidness between adjacent solar cells as well as improving the risk of breakage and warping of the photovoltaic cells during transportation, installation and normal thermal cycling. The life of the photovoltaic cell and the solar module array may be increased due to a reduction in vibration and stresses between cells when compared to conventional three bus bar technology. The solar module array may be subjected to shock and vibration during transportation or in service due to thermal cycling and may experience mechanical stress such as by wind buffeting or snow loading.

Other benefits with this design are an increase in photovoltaic cell and in solar module array durability with regard to thermal cycling during operation. The risk of overheating and/or arcing is significantly reduced or eliminated when compared to current three bus bar designs. It is known in the art that conventional three bus bar designs overheat or arc due to failure or breakage of interconnects in the three bus bars configuration. In an extreme circumstance, if even up to 1/3 of the appendages of the present cell-to-cell interconnect failed, the design enables redundancy and maintaining efficiency because the remaining appendages can still route the electrical energy produced to the adjacent photovoltaic cell and without a risk of fire.

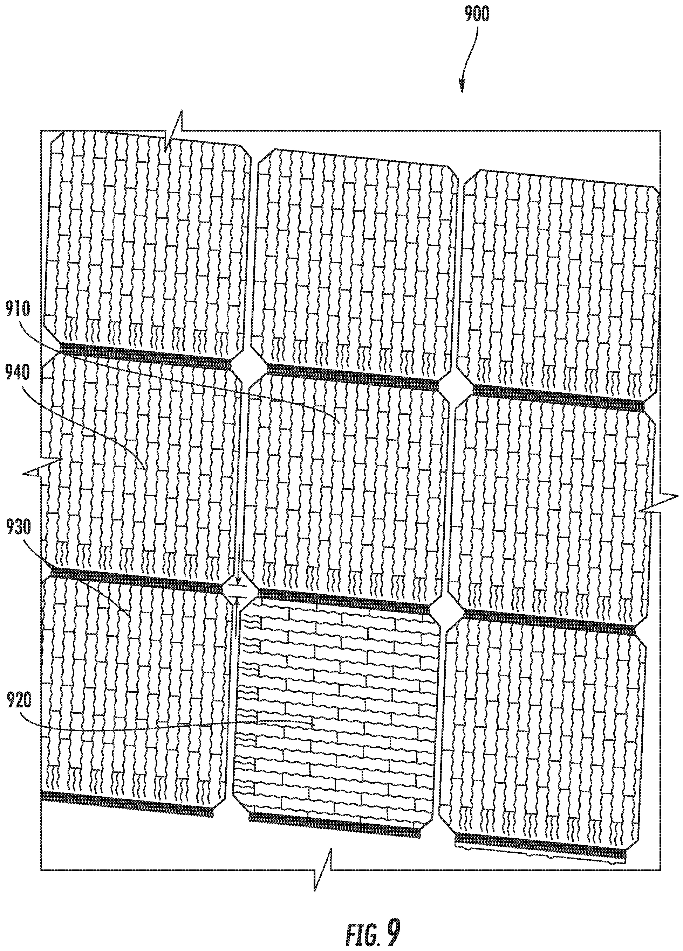

FIG. 9 illustrates a module 900 of photovoltaic cells in accordance with some examples, as would be assembled for a module. Multiple cells are shown in FIG. 9, although any number of cells - such as 36-96 - may be utilized in a module as desired. Each neighboring pair of cells is joined together as described herein. However, in the example of FIG. 9 some photovoltaic cells may be rotated 90° from the previous cell. For example, cell 920 is rotated 90° counterclockwise from cell 910 to connect to cell 930. Thus, the mesh designs that have been disclosed within can be designed with a symmetry that allows for various orientations on a cell, enabling cells within a module to be connected in any sequence as desired. The multiple photovoltaic cells of the module 900 are assembled with a gap 960 between them. The gap 960 allows for flexure of the overall module, and also assists with the flow of laminating material when encapsulating the finished module.

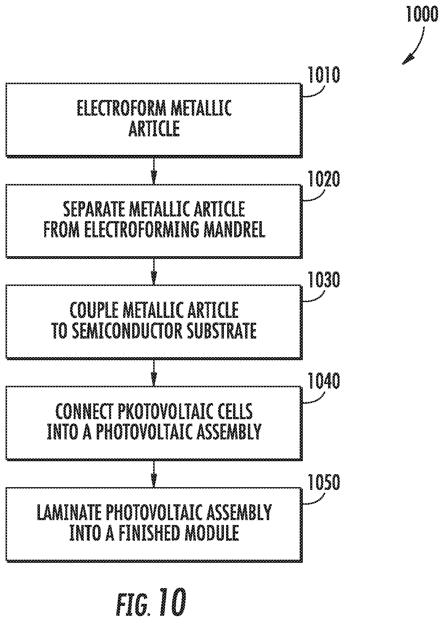

FIG. 10 is a flowchart 1000 of a method of forming an electrical component for a photovoltaic cell using metallic articles in accordance with some examples as described above. Note that although electroforming shall be described for manufacturing the metallic article, other methods are possible such as etching, stamping, assembling of wires, or machining, such as by using a laser or water jet. In step 1010, a metallic article is electroformed on an electrically conductive mandrel. The electrically conductive mandrel has an outer surface comprising at least one preformed pattern. The metallic article comprises a first region having a plurality of electroformed elements and a cell-to-cell interconnect integral with the first region. The cell-to-cell interconnect has a plurality of electroformed appendages. In some examples, the metallic article is configured to serve as an electrical conduit within a photovoltaic cell. In certain examples, the metallic article may include integral features to enable connections between photovoltaic cells of a solar module. In other examples, interconnection features may be fabricated separately and joined to the metallic article. If formed separately, the interconnection features may be formed by, for example, electroforming or stamping of sheet material. At least a portion of the finished electroformed metallic article is created within the preformed patterns.

The metallic article has a plurality of electroformed elements with customized features that may include one or more of: a) a non-uniform width along a first length of a first element, b) a change in conduit direction along the first length of the first element, c) an expansion segment along the first length of the first element, d) a first width that is different from a second width of a second element in the plurality of electroformed elements, e) a first height that is different from a second height of the second element in the plurality of electroformed elements, and f) a top surface that is textured. The metallic article may be configured to function as electrical grid lines, bus bars, cell-to-cell interconnects, and solder pads for a photovoltaic cell. The cell-to-cell interconnect may include a link having a first link end coupled to an edge of the first region, a second link end opposite the first link end and away from the edge of the first region and a tapered neck along a length of the link. The cell-to-cell interconnect may also include a plurality of appendages. Each appendage has a first end coupled to an edge of the first region and a second end opposite the first end and away from the edge of the first region. An appendage length that is greater than the length of the link. The appendages are spaced apart from each other.

Step 1010 may include contacting the outer surface of the electroforming mandrel with a solution comprising a salt of a first metal, where the first metal may be, for example copper or nickel. The first metal may form the entire metallic article, or may form a metallic precursor for layers of other metals. For example, a solution of a salt comprising a second metal may be plated over the first metal. In some examples, the first metal may be nickel and the second metal may be copper, where the nickel provides a barrier for copper diffusion. A third metal may optionally be plated over the second metal, such as the third metal being nickel over a second metal of copper, which has been plated over a first metal of nickel. In this three-layer structure, the copper conduit is encapsulated by nickel to provide a barrier against copper contamination into a semiconductor device. Electroforming process parameters in step 1010 may be, for example, currents ranging from 10.76 to 32,292 amps/m² (1 to 3000 amps per square foot (ASF)) and plating times ranging from, for example, 1 minute to 200 minutes. Other electrically conductive metals may be applied to promote adhesion, promote wettability, serve as a diffusion barrier, or to improve electrical contact, such as tin, tin alloys, indium, indium alloys, bismuth alloys, nickel tungstate, or cobalt nickel tungstate.

After the metallic article is formed, the metallic article with the plurality of electroformed elements interconnected, is separated in step 1020 from the electrically conductive mandrel to become a free-standing, unitary piece. The plurality of electroformed elements are configured to serve as an electrical conduit for a light-incident surface of the photovoltaic cell. The cell-to-cell interconnect is configured to extend beyond the light-incident surface and to directly couple the metallic article to a neighboring photovoltaic cell. The cell-to-cell interconnect includes a plurality of electroformed appendages. Each appendage has a first end coupled to an edge of the first region, and a second end opposite the first end and away from the edge. The appendages are spaced apart from each other.

The separation may involve lifting or peeling the article from the mandrel, such as manually or with the assistance of tools such as vacuum handling. Peeling may also be facilitated by using the interconnect element - such as cell-to-cell interconnect 440 of FIG. 3 - as a handle for initiating and lifting the metallic article. Links that are integral to the cell-to-cell interconnect, such as links 474 as described above, may be included to help prevent damage to the appendages during removal of the metallic article from the mandrel. In other examples, removal may include thermal or mechanical shock or ultrasonic energy to assist in releasing the fabricated part from the mandrel. The free-standing metallic article is then ready to be formed into a photovoltaic cell or other semiconductor device, by attaching and electrically coupling the article as shall be described below. Transferring of the metallic article to the various manufacturing steps may be done without need for a supporting element.

In step 1030 the metallic article is coupled to a semiconductor substrate, mechanically and electrically. Step 1030 may include coupling a front grid to the front side of a semiconductor wafer, and coupling a back grid to the back side of the wafer. The coupling may be soldering, such as manual or automated soldering. The solder may be applied at specific points such as silver solder pads that have been printed onto the wafer. In some examples, the solder may have been pre-applied onto all or some of the metallic article, such as by plating or dipping. Pre-applied solder may then be reflowed during the coupling process of step 1030. In other examples, the solder may be an active solder, and may enable bonding at non-metallized portions of the wafer as described in U.S. Provisional Patent Application, 61/868,436, entitled "Using an Active Solder to Couple a Metallic Article to a Photovoltaic Cell," filed on August 21, 2013, owned by the assignee of the present application.

Joining the metallic article to the semiconductor in step 1030 may utilize, for example, ultrasonic, infrared, hot bar, or rapid thermal processing techniques. The bonding may be performed on one joint at a time, or a region of the wafer, or the entire wafer at once. The metallic article may include expansion segments to reduce bowing or breakage that may occur from the thermal stresses induced during bonding processes.

The semiconductor wafer may undergo additional processing steps before or after step 1030, such as to apply anti-reflection coatings. The specific coatings will be dependent on the type of cell being produced, and may include, for example, dielectric anti-reflective coatings such as nitrides, or transparent conductive oxides such as indium-tin-oxide.

The prepared photovoltaic cells are then connected together in step 1040. The interconnections may be performed as described herein, for a front-to-back series connection. In other examples, the cells may be wired in parallel with front-to-front and back-to-back connections.

In step 1050, a module assembly is laminated together. In some examples, the assembly may include a backing sheet such as a polyvinyl fluoride (PVF) film, with a laminating material (e.g., EVA) placed onto the backing sheet. The photovoltaic cells are placed on the EVA sheet, and another EVA sheet on top of the cells. Finally, a glass sheet is over the top EVA sheet. In other examples, different materials may be used instead of glass and EVA to achieve a desired flexibility, durability and weight for the module. The entire layered stack is put in a laminator, where heat and vacuum are applied to laminate the assembly. To complete the module, the electrical connections of the cells are wired to a junction box.

It can be seen that the free-standing metallic article described herein is applicable to various cell types and may be inserted at different points within the manufacturing sequence of a solar cell. Furthermore, the electrical conduits may be utilized on either the front surface or rear surface of a solar cell, or both. The metallic article with the cell-to-cell interconnect described herein is suitable for flexible solar module applications. Flexible solar modules are convenient, lightweight and portable. There are many applications for flexible solar panels such as battery chargers for devices like PDAs, mobile phones, laptops and walkie-talkies. They may also be used to power camping equipment, field communication radios and GPS systems or may be integrated into architectural fabric and metal roofing.

In addition, although the examples herein have primarily been described with respect to photovoltaic applications, the methods and devices may also be applied to other semiconductor applications such as redistribution layers (RDL's) or flex circuits. Furthermore, the flowchart steps may be performed in alternate sequences, and may include additional steps not shown. Although the descriptions have described for full size cells, they may also be applicable to half-size or quarter-size cells. For example, the metallic article design may have a layout to accommodate the cell having only one or two chamfered corners instead of all four corners being chamfered as in a mono-crystalline full pseudosquare.

While the specification has been described in detail with respect to specific embodiments of the invention, it will be appreciated that those skilled in the art, upon attaining an understanding of the foregoing, may readily conceive of alterations to, variations of, and equivalents to these embodiments. These and other modifications and variations to the present invention may be practiced by those of ordinary skill in the art, without departing from the scope of the present invention, which is more particularly set forth in the appended claims. Furthermore, those of ordinary skill in the art will appreciate that the foregoing description is by way of example only, and is not intended to limit the invention.

## Claims

1. A metallic article (400) for a photovoltaic cell comprising:
a first region (456) having a plurality of elements that are configured to serve as an electrical conduit for a light-incident surface of the photovoltaic cell; and
a cell-to-cell interconnect (440) integral with the first region (456), extending beyond the light-incident surface and directly coupling the metallic article (400) to a neighboring photovoltaic cell, the cell-to-cell interconnect (440) comprising:
a link (474) having i) a first link end coupled to an edge of the first region (456), ii) a second link end opposite the first link end and away from the edge of the first region (456) and iii) a tapered neck (476) along a length of the link (474), wherein the tapered neck (476) is a breakage point when a force is applied to the cell-to-cell interconnect (440);
a plurality of appendages (460), each appendage having i) a first end (462) coupled to the edge of the first region (456), ii) a second end (466) opposite the first end (462) and away from the edge of the first region (456), and iii) an appendage length that is greater than the length of the link (474), wherein the appendages (460) are spaced apart from each other; and
wherein the metallic article (400) is a unitary, free-standing piece.

2. The metallic article (400) of claim 1, wherein:
the first region (456) comprises a first plane; and
the cell-to-cell interconnect (440) comprises a bend that places the second ends (466) of the plurality of electroformed appendages (460) in a second plane different from the first plane.

3. The metallic article (400) of claim 2, wherein the bend is configured at an angle of 5° to 85° relative to the plane of the metallic article (400).

4. The metallic article (400) of claim 3, wherein:
the cell-to-cell interconnect (440) protrudes from the first plane by 0.2-0.4 mm; and
the cell-to-cell interconnect (440) protrudes from the second plane by 0.3-0.6 mm.

5. The metallic article (400) of claim 1, wherein a thickness of the cell-to-cell interconnect (440) comprises a height that is different from a height of the plurality of elements.

6. The metallic article (400) of claim 1, wherein the link is linear and is perpendicular to the edge of the first region.

7. The metallic article (400) of claim 1, wherein the appendage (460) is repeated at least 8 times per centimeter, at least 10 per centimeter, or at least 12 per centimeter.

8. The metallic article (400) of claim 1, wherein each appendage (460) of the plurality of appendages (460) is hourglass shaped, S-shaped, U-shaped, W-shaped, V-shaped, serpentine shaped, saw-tooth shaped or L-shaped.

9. The metallic article (400) of claim 1, wherein the appendage length is a path length along the appendage (460), and the appendage length is from 1.4 to 3 times the length of the link.

10. The metallic article (400) of claim 1, wherein an angle between the tangent of the appendage (460) and a horizontal edge of the first region (456) is at least 12°.

11. The metallic article (400) of claim 1, further comprising:
a metallic strip (470) integral with the cell-to-cell interconnect (440) and coupled to the second ends of the plurality of appendages (460), wherein the metallic strip (470) is configured to be coupled to a back side of the neighboring photovoltaic cell.

12. The metallic article (400) of claim 11, wherein each appendage (460) traverses a non-perpendicular path between the edge of the first region (456) and the metallic strip (470).

13. The metallic article (400) of claim 1, wherein the cell-to-cell interconnect (440) further comprises a crossbar (478) extending across the plurality of appendages (460) and connecting one appendage to a neighboring appendage.

14. A method of forming an electrical component for a photovoltaic cell, the method comprising:
electroforming a metallic article (400) on an electrically conductive mandrel (100), wherein the electrically conductive mandrel (100) has an outer surface comprising at least one preformed pattern, wherein the metallic article (400) comprises a first region (456) having a plurality of electroformed elements and a cell-to-cell interconnect (440) integral with the first region (456); and
separating the metallic article (400) from the electrically conductive mandrel (100), wherein the plurality of electroformed elements is interconnected such that the metallic article (400) forms a unitary, free-standing piece when separated from the electrically conductive mandrel (100);
wherein the plurality of electroformed elements is configured to serve as an electrical conduit for a light-incident surface of the photovoltaic cell;
wherein the cell-to-cell interconnect extends beyond the light-incident surface and directly couples the metallic article (400) to a neighboring photovoltaic cell and comprises:
a link (474) having i) a first link end coupled to an edge of the first region (456), ii) a second link end opposite the first link end and away from the edge of the first region (456) and iii) a tapered neck (476) along a length of the link (474), wherein the tapered neck (476) is a breakage point when a force is applied to the cell-to-cell interconnect (440);
a plurality of appendages (460), each appendage having i) a first end (462) coupled to the edge of the first region (456), ii) a second end (466) opposite the first end (462) and away from the edge of the first region (456), and iii) an appendage length that is greater than the length of the link (474), wherein the appendages (460) are spaced apart from each other.

## Patentansprüche

1. Metallischer Gegenstand (400) für eine Solarzelle, umfassend:
einen ersten Bereich (456), der eine Vielzahl von Elementen aufweist, die konfiguriert sind, um als Stromleitung für eine Lichteinfallsfläche der Solarzelle zu dienen; und
eine Zwischenverbindung von Zelle zu Zelle (440), die einstückig mit dem ersten Bereich (456) ist, sich über die Lichteinfallsfläche hinaus erstreckt und den metallischen Gegenstand (400) direkt mit einer benachbarten Solarzelle koppelt, die Zwischenverbindung von Zelle zu Zelle (440) umfassend:
ein Verbindungsglied (474), das i) ein erstes Verbindungsgliedende aufweist, das mit einem Rand des ersten Bereichs (456) gekoppelt ist, ii) ein zweites Verbindungsgliedende gegenüber dem ersten Verbindungsgliedende und weg von dem Rand des ersten Bereichs (456), und iii) einen sich verjüngenden Hals (476) entlang einer Länge des Verbindungsglieds (474) aufweist, wobei der sich verjüngende Hals (476) eine Bruchstelle ist, wenn eine Kraft auf die Zwischenverbindung von Zelle zu Zelle (440) ausgeübt wird;
eine Vielzahl von Ansätzen (460), wobei jeder Ansatz i) ein erstes Ende (462), das mit der Rand des ersten Bereichs (456) verbunden ist, ii) ein zweites Ende (466) gegenüber dem ersten Ende (462) und entfernt von der Rand des ersten Bereichs (456) und iii) eine Ansatzlänge, die größer als die Länge des Verbindungsglieds (474) ist, aufweist, wobei die Ansätze (460) voneinander beabstandet sind; und wobei der metallische Gegenstand (400) ein einheitliches, freistehendes Stück ist.

2. Metallischer Gegenstand (400) gemäß Anspruch 1, wobei:
der erste Bereich (456) eine erste Ebene umfasst; und
die Zwischenverbindung von Zelle zu Zelle (440) eine Biegung aufweist, die die zweiten Enden (466) der Vielzahl von elektrogeformten Ansätzen (460) in einer zweiten Ebene platziert, die sich von der ersten Ebene unterscheidet.

3. Metallischer Gegenstand (400) gemäß Anspruch 2, wobei die Biegung in einem Winkel von 5° bis 85° in Bezug auf die Ebene des metallischen Gegenstands (400) konfiguriert ist.

4. Metallischer Gegenstand (400) gemäß Anspruch 3, wobei:
die Zwischenverbindung von Zelle zu Zelle (440) um 0,2-0,4 mm von der ersten Ebene hervorsteht; und
die Zwischenverbindung von Zelle zu Zelle (440) von der zweiten Ebene um 0,3-0,6 mm hervorsteht.

5. Metallischer Gegenstand (400) gemäß Anspruch 1, wobei eine Stärke der Zwischenverbindung von Zelle zu Zelle (440) eine Höhe umfasst, die sich von einer Höhe der Vielzahl von Elementen unterscheidet.

6. Metallischer Gegenstand (400) gemäß Anspruch 1, wobei die Verbindung linear ist und senkrecht zu dem Rand des ersten Bereichs ist.

7. Metallischer Gegenstand (400) gemäß Anspruch 1, wobei sich das Ansatz (460) mindestens 8 Mal pro Zentimeter, mindestens 10 Mal pro Zentimeter oder mindestens 12 Mal pro Zentimeter wiederholt.

8. Metallischer Gegenstand (400) gemäß Anspruch 1, wobei jeder Ansatz (460) der Vielzahl von Ansätzen (460) sanduhrförmig, S-förmig, U-förmig, W-förmig, V-förmig, schlangenförmig, sägezahnförmig oder L-förmig ist.

9. Metallischer Gegenstand (400) gemäß Anspruch 1, wobei eine Länge des Ansatzes eine Weglänge entlang des Ansatzes (460) ist und die Länge des Ansatzes das 1,4- bis 3-fache der Länge des Verbindungsglieds ist.

10. Metallischer Gegenstand (400) gemäß Anspruch 1, wobei ein Winkel zwischen der Tangente des Ansatzes (460) und einem horizontalen Rand des ersten Bereichs (456) mindestens 12° ist.

11. Metallischer Gegenstand (400) gemäß Anspruch 1, ferner umfassend:
einen Metallstreifen (470), der einstückig mit der Zwischenverbindung von Zelle zu Zelle (440) ist und mit den zweiten Enden der Vielzahl von Ansätzen (460) verbunden ist, wobei der Metallstreifen (470) konfiguriert ist, um mit einer Rückseite der benachbarten Solarzelle verbunden zu sein.

12. Metallischer Gegenstand (400) gemäß Anspruch 11, wobei jeder Ansatz (460) einen nicht senkrechten Pfad zwischen dem Rand des ersten Bereichs (456) und dem metallischen Streifen (470) durchläuft.

13. Metallischer Gegenstand (400) gemäß Anspruch 1, wobei die Zwischenverbindung von Zelle zu Zelle (440) ferner einen Querbalken (478) umfasst, der sich über die Vielzahl von Ansätzen (460) erstreckt und einen Ansatz mit einem benachbarten Ansatz verbindet.

14. Verfahren zum Bilden einer elektrischen Komponente für eine Solarzelle, das Verfahren umfassend:
Elektroformen eines metallischen Gegenstands (400) auf einem elektrisch leitenden Dorn (100), wobei der elektrisch leitende Dorn (100) eine äußere Oberfläche aufweist, die mindestens ein vorgeformtes Muster umfasst, wobei der metallische Gegenstand (400) einen ersten Bereich (456), der eine Vielzahl von elektrogeformten Elementen und eine Zwischenverbindung von Zelle zu Zelle (440), die mit dem ersten Bereich (456) einstückig ist, umfasst; und
Trennen des metallischen Gegenstands (400) von dem elektrisch leitenden Dorn (100), wobei die Vielzahl von elektrogeformten Elementen miteinander verbunden ist, sodass der metallische Gegenstand (400) ein einheitliches, freistehendes Stück bildet, wenn er von dem elektrisch leitenden Dorn (100) getrennt ist;
wobei die Vielzahl der elektrogeformten Elemente konfiguriert ist, um als Stromleitung für eine Lichteinfallsfläche der Solarzelle zu dienen;
wobei sich die Zwischenverbindung von Zelle zu Zelle über die Lichteinfallsfläche hinaus erstreckt und den metallischen Gegenstand (400) direkt mit einer benachbarten Solarzelle koppelt und Folgendes umfasst:
ein Verbindungsglied (474), das i) ein erstes Verbindungsgliedende aufweist, das mit einem Rand des ersten Bereichs (456) gekoppelt ist, ii) ein zweites Verbindungsgliedende gegenüber dem ersten Verbindungsgliedende und weg von dem Rand des ersten Bereichs (456), und iii) einen sich verjüngenden Hals (476) entlang einer Länge des Verbindungsglieds (474) aufweist, wobei der sich verjüngende Hals (476) eine Bruchstelle ist, wenn eine Kraft auf die Zwischenverbindung von Zelle zu Zelle (440) ausgeübt wird;
eine Vielzahl von Ansätzen (460), wobei jeder Ansatz i) ein erstes Ende (462), das mit der Rand des ersten Bereichs (456) verbunden ist, ii) ein zweites Ende (466) gegenüber dem ersten Ende (462) und entfernt von der Rand des ersten Bereichs (456) und
iii) eine Ansatzlänge, die größer als die Länge des Verbindungsglieds (474) ist, aufweist, wobei die Ansätze (460) voneinander beabstandet sind.

## Revendications

1. Un article métallique (400) pour une cellule photovoltaïque comprenant :
une première région (456) comportant une pluralité d'éléments configurés pour servir de conduit électrique pour une surface d'incidence de lumière de la cellule photovoltaïque ; et
une interconnexion intercellulaire (440) intégrée à la première région (456), s'étendant au-delà de la surface d'incidence de lumière et couplant directement l'article métallique (400) à une cellule photovoltaïque voisine, l'interconnexion intercellulaire (440) comprenant :
une liaison (474) ayant i) une première extrémité de liaison couplée à un bord de la première région (456), ii) une deuxième extrémité de liaison opposée à la première extrémité de liaison et éloignée du bord de la première région (456) et iii) un col effilé (476) sur une longueur de la liaison (474), dans lequel le col effilé (476) est un point de rupture lorsqu'une force est appliquée à l'interconnexion intercellulaire (440) ;
une pluralité d'appendices (460), chaque appendice ayant i) une première extrémité (462) couplée au bord de la première région (456), ii) une deuxième extrémité (466) opposée à la première extrémité (462) et éloignée du bord de la première région (456), et iii) une longueur d'appendice supérieure à la longueur de la liaison (474),
dans lequel les appendices (460) sont espacés les uns des autres ; et
dans lequel l'article métallique (400) est une pièce unitaire et autonome.

2. L'article métallique (400) selon la revendication 1, dans lequel :
la première région (456) comprend un premier plan ; et
l'interconnexion intercellulaire (440) comprend une courbure qui place les deuxièmes extrémités (466) de la pluralité d'appendices électroformés (460) dans un deuxième plan différent du premier plan.

3. L'article métallique (400) selon la revendication 2, dans lequel la courbure est configurée à un angle de 5° à 85° par rapport au plan de l'article métallique (400).

4. L'article métallique (400) selon la revendication 3, dans lequel :
l'interconnexion intercellulaire (440) dépasse le premier plan de 0,2 à 0,4 mm ; et
l'interconnexion intercellulaire (440) dépasse le deuxième plan de 0,3 à 0,6 mm.

5. L'article métallique (400) selon la revendication 1, dans lequel une épaisseur de l'interconnexion intercellulaire (440) comprend une hauteur qui est différente d'une hauteur de la pluralité d'éléments.

6. L'article métallique (400) selon la revendication 1, dans lequel la liaison est linéaire et perpendiculaire au bord de la première région.

7. L'article métallique (400) selon la revendication 1, dans lequel l'appendice (460) est répété au moins 8 fois par centimètre, au moins 10 fois par centimètre, ou au moins 12 fois par centimètre.

8. L'article métallique (400) selon la revendication 1, dans lequel chaque appendice (460) de la pluralité d'appendices (460) est en forme de sablier, en forme de S, en forme de U, en forme de W, en forme de V, en forme de serpentin, en forme de dents de scie ou en forme de L.

9. L'article métallique (400) selon la revendication 1, dans lequel la longueur de l'appendice est une longueur de trajet le long de l'appendice (460), et la longueur de l'appendice est de 1,4 à 3 fois la longueur de la liaison.

10. L'article métallique (400) selon la revendication 1, dans lequel un angle entre la tangente de l'appendice (460) et un bord horizontal de la première région (456) est d'au moins 12°.

11. L'article métallique (400) selon la revendication 1, comprenant en outre :
une bande métallique (470) intégrée à l'interconnexion intercellulaire (440) et couplée aux deuxièmes extrémités de la pluralité d'appendices (460), dans laquelle la bande métallique (470) est configurée pour être couplée à un côté arrière de la cellule photovoltaïque voisine.

12. L'article métallique (400) selon la revendication 11, dans lequel chaque appendice (460) traverse un trajet non perpendiculaire entre le bord de la première région (456) et la bande métallique (470).

13. L'article métallique (400) selon la revendication 1, dans lequel l'interconnexion intercellulaire (440) comprend en outre une barre transversale (478) s'étendant à travers la pluralité d'appendices (460) et reliant un appendice à un appendice voisin.

14. Un procédé de formation d'un composant électrique pour une cellule photovoltaïque, le procédé comprenant :
l'électroformage d'un article métallique (400) sur un mandrin électroconducteur (100), dans lequel le mandrin électroconducteur (100) a une surface extérieure comprenant au moins un motif préformé, dans lequel l'article métallique (400) comprend une première région (456) ayant une pluralité d'éléments électroformés et une interconnexion intercellulaire (440) intégrée à la première région (456) ; et
la séparation de l'article métallique (400) du mandrin électroconducteur (100), dans lequel la pluralité d'éléments électroformés est interconnectée de telle sorte que l'article métallique (400) forme une pièce unitaire et autonome lorsqu'il est séparé du mandrin électroconducteur (100) ;
dans lequel la pluralité d'éléments électroformés est configurée pour servir de conduit électrique pour une surface d'incidence de lumière de la cellule photovoltaïque ;
dans lequel l'interconnexion intercellulaire s'étend au-delà de la surface d'incidence de lumière et couple directement l'article métallique (400) à une cellule photovoltaïque voisine et comprend :
une liaison (474) ayant i) une première extrémité de liaison couplée à un bord de la première région (456), ii) une deuxième extrémité de liaison opposée à la première extrémité de liaison et éloignée du bord de la première région (456) et iii) un col effilé (476) sur une longueur de la liaison (474), dans lequel le col effilé (476) est un point de rupture lorsqu'une force est appliquée à l'interconnexion intercellulaire (440) ;
une pluralité d'appendices (460), chaque appendice ayant i) une première extrémité (462) couplée au bord de la première région (456), ii) une deuxième extrémité (466) opposée à la première extrémité (462) et éloignée du bord de la première région (456), et iii) une longueur d'appendice supérieure à la longueur de la liaison (474), dans lequel les appendices (460) sont espacés les uns des autres.
